Europäisches Patentamt

(19) European Patent Office

Office européen des brevets

(11) **EP 0 938 199 A2**

(12) **EUROPEAN PATENT APPLICATION**

(43) Date of publication:
25.08.1999 Bulletin 1999/34

(51) Int. Cl.⁶: **H04H 1/00**, H03J 1/00

(21) Application number: 99300584.2

(22) Date of filing: 27.01.1999

(84) Designated Contracting States:
AT BE CH CY DE DK ES FI FR GB GR IE IT LI LU
MC NL PT SE
Designated Extension States:
AL LT LV MK RO SI

(30) Priority: 19.02.1998 JP 3741398

(71) Applicant: FUJITSU TEN LIMITED
Kobe-shi, Hyogo (JP)

(72) Inventor: Nagami, Masaaki
Kobe-shi, Hyogo (JP)

(74) Representative:
Skone James, Robert Edmund
GILL JENNINGS & EVERY
Broadgate House
7 Eldon Street
London EC2M 7LH (GB)

(54) **Means for determining available reception frequencies in a receiver for the reception of digital broadcasts**

(57) In a digital broadcast receiver, receivable frequencies are calculated, a receiving unit (10) judges whether a broadcasting wave is present at each of the calculated frequencies, and frequencies at which the broadcasting wave is present are displayed on a display unit (40). The receivable frequencies can thus be displayed quickly. Thereafter, broadcast information is read from the receiving unit (10) relative to each of the frequencies at which the broadcasting wave is present. The broadcast information is displayed on the display unit (40). Broadcast information can thus be read relative only to the frequencies at which the broadcasting wave is present. The time required for displaying all the broadcast information is therefore shortened.

Fig.1

## Description

The present invention relates to a digital broadcast receiver.

Digital broadcast receivers are employed in digital broadcasting (for example, digital audio broadcasting (DAB)), wherein broadcast information is searched for. The broadcast information includes names of broadcasting stations that transmit waves receivable in a region in which a receiver is located, and the contents of broadcasts. The broadcast information concerning the broadcasting stations that transmit receivable waves is then displayed on a display unit. Users view the display unit and select a desired broadcasting station.

In the foregoing digital broadcast receiver of a related art, all set frequencies are searched. Synchronization and information acquisition that are time-consuming are carried out relative to even a frequency unallocated to any broadcasting station. Much time is therefore required from the start of searching to the end thereof because even a frequency unallocated to any broadcasting station is checked by taking much time.

The present invention attempts to accomplish the above object. According to the present invention, there is provided a digital broadcast receiver comprising a receiving unit, a synchronizing unit, a control unit, and a display unit. The control unit includes a frequency calculating unit, a broadcasting wave judging unit, a frequency recording unit, and an information recording unit. The frequency calculating unit calculates frequencies at which receivable broadcast information is to be searched for. The broadcasting wave judging unit judges whether a broadcasting wave is present at the frequencies calculated by the calculating unit. Frequencies, at which it has been judged by said broadcasting wave judging unit that the broadcasting wave is present, are recorded in the frequency recording unit. Acquired information is recorded in the information recording unit.

In the control unit, the frequency calculating unit calculates frequencies. The calculated frequencies are set as radio frequencies to be monitored by the receiving unit one by one. The broadcasting wave judging unit judges whether a broadcasting wave is present at each of the calculated frequencies. Frequencies at which the broadcasting wave is present are recorded in the frequency recording unit. After judging whether the broadcasting wave is present is completed relative to all the frequencies, the frequencies recorded in the frequency recording unit are set as radio frequencies to be received in the receiving unit. The synchronising unit helps attain synchronism. Broadcasting information read from the receiving unit is recorded in the information recording unit. The contents of the information recorded in the information recording unit are displayed on the display unit.

According to the present invention, during searching and relative to the frequencies at which the broadcasting wave is present, the digital broadcast receiver sets the frequencies as radio frequencies to be received, attains synchronism, and acquires information. On the contrary, relative to frequencies at which the broadcasting wave is absent, the digital broadcast receiver merely sets the frequencies as radio frequencies not to be received. However, synchronization and information acquisition are not carried out. Setting as radio frequencies, that requires relatively little time, is performed on all the frequencies. Synchronization and information acquisition that are relatively time-consuming are performed only on the frequencies at which information can be acquired. The time required for searching can be shortened.

The broadcasting wave judging unit may judge whether the broadcasting wave is present at each of the frequencies. When frequencies at which the broadcasting wave is present are recorded in the frequency recording unit, the frequencies are displayed on the display unit at the same time. When searching is completed relative to all the frequencies, the contents of acquired information can be additionally displayed on the display unit displaying the frequencies. Thus, receivable frequencies can be displayed more quickly.

Furthermore, the broadcasting wave judging unit can sense whether a signal resulting from fast Fourier transform (FFT) performed by the digital block of the receiving unit is present. Moreover, the broadcasting wave judging unit can judge from signal levels whether the broadcasting wave is present. Herein, the signal levels are sensed by a level sensing unit included in the analog block of the receiving unit.

Features of the present invention will be more apparent from the following description of the preferred embodiment with reference to the accompanying drawings, wherein:

FIG. 1 is a diagram showing the configuration of a digital broadcast receiver in accordance with a related art;

FIG. 2 is a flowchart describing the operations of the receiver shown in FIG. 1;

FIG. 3 is a diagram showing the configuration of a digital broadcast receiver in accordance with an A mode of the present invention;

FIG. 4 is a flowchart describing the operations of the receiver shown in FIG. 3;

FIG. 5 is a diagram showing the configuration of a digital broadcast receiver in accordance with a B mode of the present invention;

FIG. 6 is a flowchart describing the operations of the receiver shown in FIG. 5;

FIG. 7 is a diagram showing the configuration of a digital broadcast receiver in accordance with a C mode of the present invention;

FIG. 8 is a diagram for explaining a first judging method of judging whether a broadcasting wave is present according to the C mode;

FIG. 9 is a diagram for explaining a second judging method of judging whether a broadcasting wave is present according to the C mode;

FIG. 10 is a diagram for explaining a third judging method of judging whether a broadcasting wave is present according to the C mode;

FIG. 11 is a diagram for explaining a fourth judging method of judging whether a broadcasting wave is present according to the C mode;

FIG. 12 is a diagram for explaining a first judging method of judging whether a broadcasting wave is present according to the D mode of the present invention;

FIG. 13 is a diagram for explaining a second judging method of judging whether a broadcasting wave is present according to the D mode of the present invention;

FIG. 14 is a diagram for explaining a third judging method of judging whether a broadcasting wave is present according to the D mode of the present invention;

FIG. 15 is a diagram for explaining a first judging method of judging whether a broadcasting wave is present according to the E mode of the present invention;

FIG. 16 is a diagram for explaining a second judging method of judging whether a broadcasting wave is present according to the E mode of the present invention;

FIG. 17 is a diagram showing a variant of the digital broadcast receiver in accordance with the C mode shown in FIG. 7;

FIG. 18 is a diagram for explaining a judging method of judging whether a broadcasting wave is present which is adopted for the receiver shown in FIG. 17;

FIG. 19 is a diagram showing the configuration of a digital broadcast receiver in accordance with an F mode of the present invention;

FIG. 20 is a diagram showing a variant of the receiver in accordance with the F mode;

FIG. 21 is a diagram showing the configuration of a digital broadcast receiver in accordance with a G mode of the present invention;

FIG. 22 is a diagram showing a variant of the receiver in accordance with the G mode; and

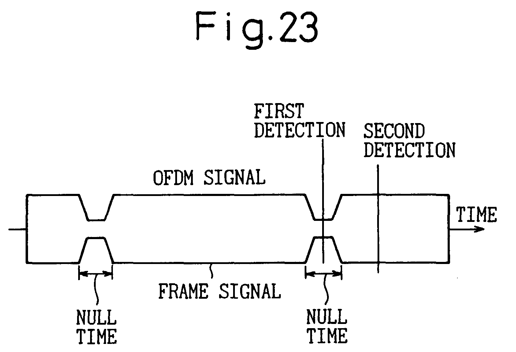

FIG. 23 is a diagram for explaining the reason why a judgment is made over a time longer than a null time in the C to G modes.

Before describing the embodiments of the present invention, the related art and the disadvantage therein will be descried with reference to the related figures.

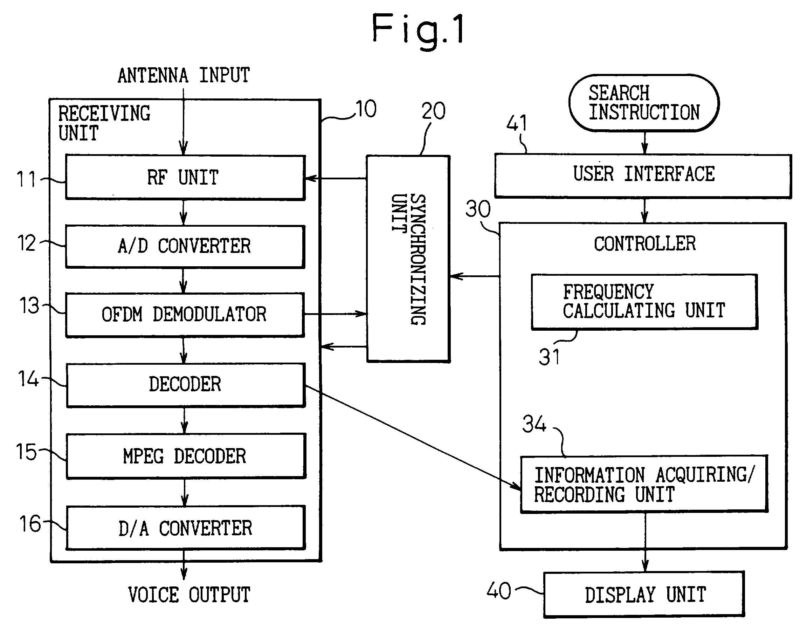

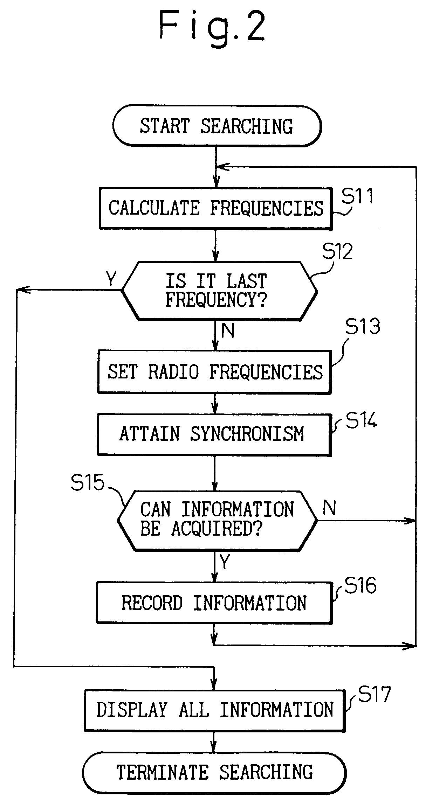

FIG. 1 is a diagram showing the configuration of a digital broadcast receiver in accordance with a related art. FIG. 2 is a flowchart describing the operations of the receiver.

The digital broadcast receiver consists of a receiving unit 10, a synchronizing unit 20, a controller 30, and a display unit 40.

At the beginning of searching, a frequency calculating unit 31 in the controller 30 calculates frequencies (step S11). If searching has not been completed relative to all frequencies (in the negative at step S12), calculated frequencies are set in a radio frequency (RF) unit 11 (step S13). The synchronizing unit 20 helps attain synchronism (step S14). An information acquiring/recording unit 34 acquires information. It is judged whether information has been acquired (step S15). If information has been acquired (in the affirmative), the acquired information is recorded in the information acquiring/recording unit 34 (step S16). Control is then returned to step S11. If information has not been acquired (in the negative), control is returned directly to step S11.

The same processing is carried out repeatedly. When searching has been completed relative to all frequencies (in the affirmative at step S12), all the information recorded in the information acquiring/recording unit 34 is displayed on the display unit 40 (step S17). Searching is then terminated.

A user of the receiver references the information displayed on the display unit 40, and selects a desired program.

As mentioned above, in the digital broadcast receiver of the related art, even frequencies unallocated to any broadcasting station are checked and this takes some time. Much time is required from the start of searching to the end thereof.

Embodiments of the present invention will be described in conjunction with the drawings below. Described below are cases in which the present invention is adapted to digital audio broadcasting (DAB) utilizing orthogonal frequency division multiplex (OFDM) as a modulation technique. In the drawings referred to below, the same reference numerals will be assigned to components having the same abilities. Repetitive descriptions will be avoided.

(A mode)

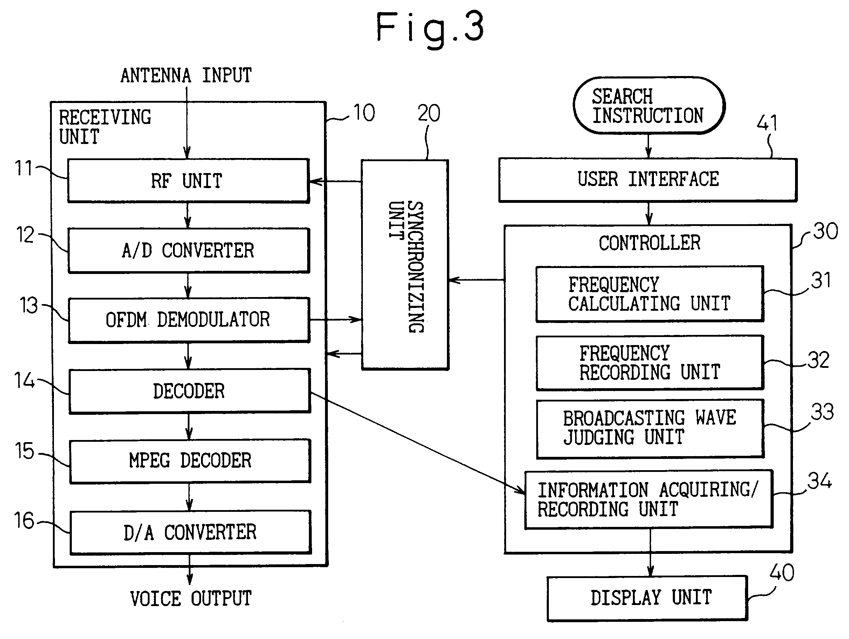

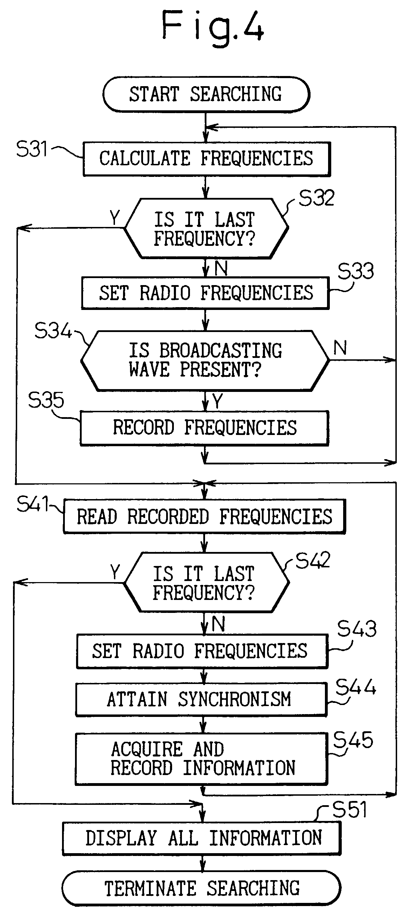

The first embodiment of the present invention (hereinafter referred to as an A mode) will be described in conjunction with FIG. 3 and FIG. 4. FIG. 3 is a diagram showing the configuration of a digital broadcast receiver.

The digital broadcast receiver consists of a receiving unit 10, a synchronizing unit 20, a controller 30, and a display unit 40.

The receiving unit 10 consists of a radio frequency (RF) unit 11, an analog-to-digital (A/D) converter 12, an OFDM demodulator 13, a decoder 14, a Moving Picture Experts Group-based decoder (hereinafter MPEG decoder) 15, and a digital-to-analog (D/A) converter 16. An antenna input is input to the RF unit 11. A voice output is output from the D/A converter 16. The synchronizing unit 20 helps the RF unit 11 attain synchronism according to an output of the OFDM demodulator 13. The configurations and operations of the receiving unit 10 and synchronizing unit 20 are already known by the people with an ordinary skill in the art. The description of the configurations and operations will therefore be omitted.

The controller 30 is realized with a CPU, a memory, and others. The controller 30 includes a frequency calculating unit 31, a frequency recording unit 32, a broadcasting wave judging unit 33, and an information acquiring/recording unit 34. When a search instruction is input via a user interface 41, the operations described below are carried out. The result is displayed on the display unit 40.

FIG. 4 is a flowchart describing the operations performed by the controller 30 during searching.

At the beginning of searching, the controller 30 uses the frequency calculating unit 31 to calculate frequencies to be checked to search for a digital broadcasting signal (step S31). If this has not been completed (in the negative at step S32), control is passed to a step of judging whether the broadcasting wave is present.

The calculated frequencies are set in the RF unit 11 (step S33). The broadcasting wave judging unit 33 judges whether the broadcasting waves are present at the frequencies (step S34). Various techniques are available as methods of judging the presence of a broadcasting wave. A practical method will be described later. If it is judged that the broadcasting wave is present (in the affirmative at step S34), the frequencies are recorded in the frequency recording unit 32 (step S35). Control is the returned to step S31. If it is judged that the broadcasting wave is absent, control is returned directly to step S31.

Frequencies to be checked during the next search are calculated at step S31. Hereinafter, the same operations as the foregoing ones are repeated. Relative to all the frequencies within the frequency band allocated to digital broadcasting, it is thus judged whether the broadcasting wave is present. Frequencies, within the frequency band allocated for digital broadcasting, at which broadcasting waves are present are recorded in the frequency recording unit 32.

When judging if the broadcasting wave is present has been completed relative to all the frequencies within the frequency band allocated for digital broadcasting (in the affirmative at step S32), control is passed to step S41. At step S41 and thereafter, information is acquired and then displayed.

One of the frequencies recorded in the frequency recording unit 32 is read out (step S41). If it has not been completed to read all the frequencies (in the negative at step S42), the frequencies that have not been read are set in the RF unit 11 (step S43). The synchronizing unit 20 helps attain synchronism (step S44). Broadcast information is received from the decoder 14, and recorded in the information acquiring/recording unit 34 (step S45).

Thereafter, control is returned to step S41. The same operations as the foregoing ones are performed repeatedly. Broadcast information concerning broadcasting stations that transmit receivable signals is accumulated in the information acquiring/recording unit 34. When it is completed to read the frequencies recorded in the frequency recording unit 32 (in the affirmative at step S42), all the information recorded in the information acquiring/recording unit 34 is displayed on the display unit 40.

Consequently, broadcast information such as broadcasting stations for transmitting waves receivable in the region and the contents of broadcasts is displayed on the display unit 40. According to this embodiment, the time required from the start of searching to the end thereof can be shortened drastically compared with that in the related art. The reasons will be described later more particularly by employing numerical values.

Assume that a transmission mode is I, the total number of frequencies is 40, the number of receivable frequencies is 5, and the times required for operations are as per set forth below:

A: time required for setting frequencies in the RF unit: 10 msec (PLL time)
B: time required for attaining synchronism: at least 100 msec (one frame)
C: time required for acquiring information: at least 300 msec (several frames)

Under the above conditions, the time S required for searching becomes different between the related art and the A mode as follows:

(Related art) $S = (A+B+C) \times 40 = 410 \times 40 = 16400$ msec (16.4 sec)

(A mode) S=A×40+(A+B+C)×5=10×40+410×5
=2450 msec (2.45 sec)

Apparently, it takes 16.4 sec to complete searching according to the related art, while it takes 2.45 sec according to the A mode. The time required for the entire searching can be shortened drastically. This is attributable to the fact that according to the A mode, synchronization and information acquisition which are time-consuming are carried out relative only to frequencies at which a broadcasting wave is present. However, setting of radio frequencies which requires relatively little time is carried out relative to all frequencies.

(B mode)

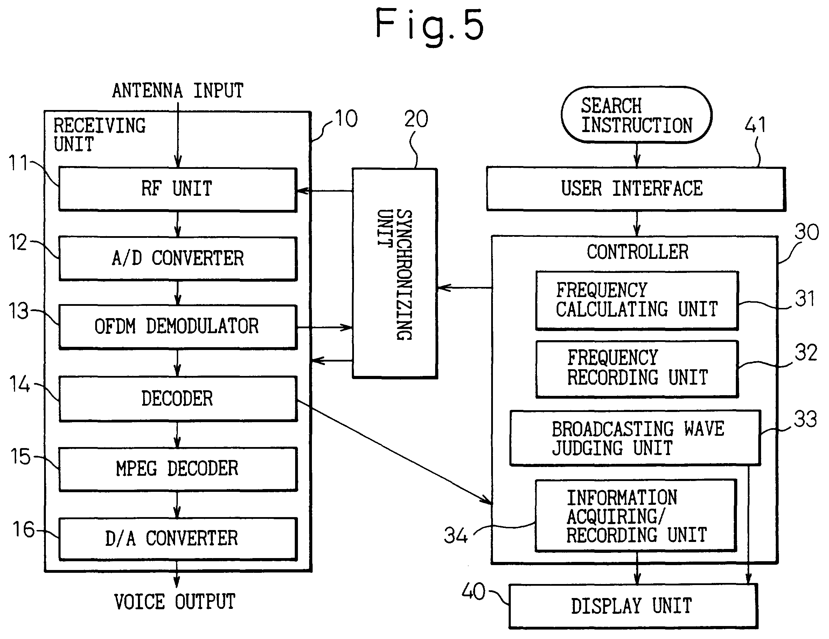

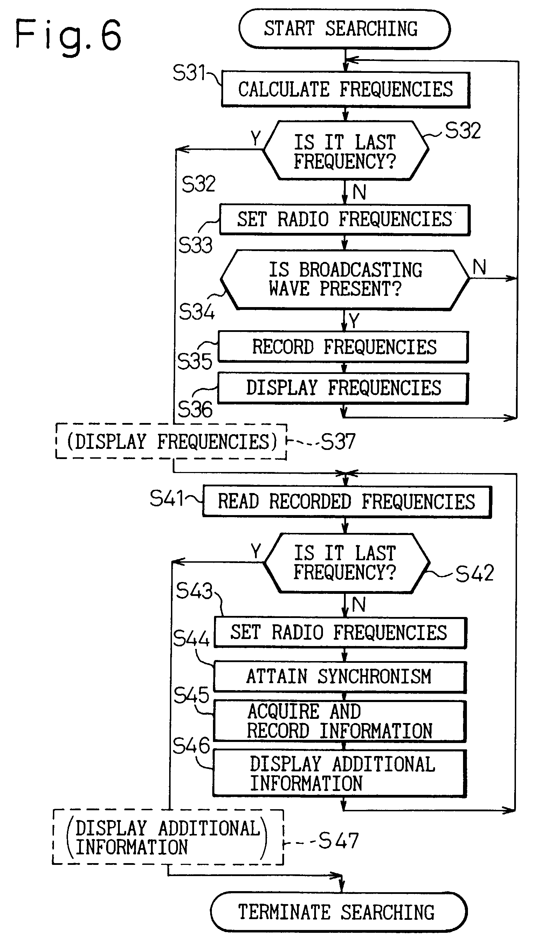

The second embodiment (hereinafter referred to as B mode) of the present invention will be described in conjunction with FIG. 5 and FIG. 6. A difference from the aforesaid A mode lies in a point that when receivable frequencies are sensed, the frequencies are displayed first, and the other information is displayed in addition to the displayed frequencies.
FIG. 5 is a diagram showing the configuration of a digital broadcast receiver, and FIG. 6 is a flowchart describing the operations of the receiver.
A difference of the receiver shown in FIG. 5 from the A-mode receiver shown in FIG. 3 lies only in the point that frequencies recorded in the frequency recording unit 33 are displayed on the display unit 40. The other points are identical to those shown in FIG. 3.
The flowchart of FIG. 6 will be referred to by pointing out differences from that of FIG. 4 concerning the A mode.
In the B mode, at steps S31 to S35, it is judged whether a broadcasting wave is present. The frequencies at which the broadcasting wave is present are recorded in the frequency recording unit 32 (step S35). Subsequently, at an additional step (step S36), the frequencies are displayed on the display unit 40. Thus, receivable frequencies are displayed on the display unit 40 prior to synchronization (step S44) and information acquisition (step S45). The time required until frequencies are displayed is even shorter than that in the aforesaid A mode.
Frequencies may not be recorded in the frequency recording unit 32 (step S36). Instead, after judging if the broadcasting wave is present is completed relative to all frequencies (in the affirmative at step S32), all the frequencies recorded in the frequency recording unit 32 may be displayed at a time on the display unit 40 (step S37). Even in this case, the frequencies are displayed at an earlier stage.
At the subsequent steps S41 to S45, information is acquired. In the B mode, after the acquired information is recorded in the information acquiring/recording unit 34 (step S45), the information is displayed additionally to the frequencies displayed on the display unit 40 at an additional step (step S46). Moreover, in the B mode, it is omitted to display all information (step S51) described in FIG. 3 concerning the A mode.
Moreover, every time information is acquired and recorded, the additional information may not be displayed (step S46). Otherwise, after information acquisition is completed relative to all frequencies (in the affirmative at step S42), all information recorded in the information acquiring/recording unit 34 may be displayed additionally (step S47).
In the aforesaid A mode and B mode, the broadcasting wave judging unit 33 in the controller 30 judges if a broadcasting wave is present. Next, a description will be made of another mode in which the broadcasting wave judging unit makes a judgment in a different way.

(C mode)

A C mode will be described, wherein whether a broadcasting wave is present is judged based on a signal resulting from fast Fourier transform (FFT) performed by a digital block in the receiving unit.

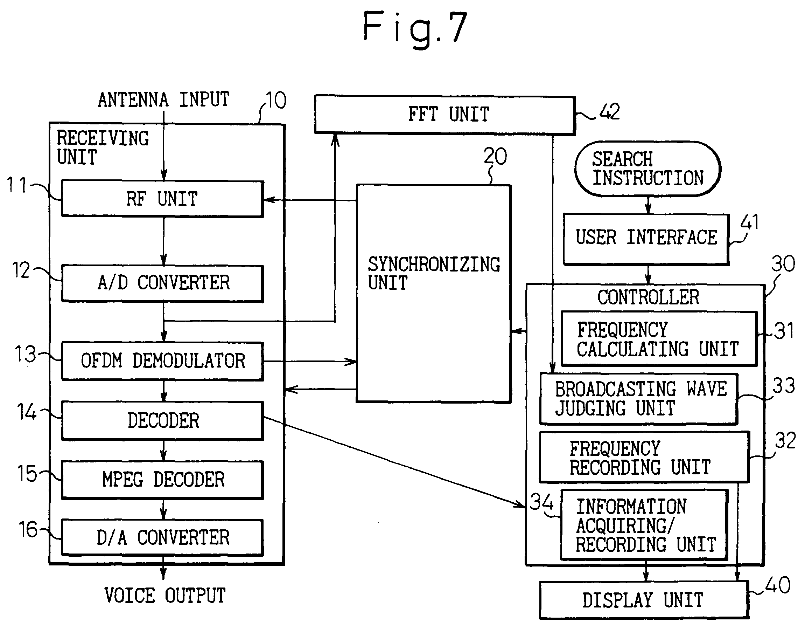

FIG. 7 shows the configuration of a receiver adopting the C mode.
In the receiver shown in FIG. 7, an FFT unit 42 is connected to a digital block on the output stage of the A/D converter 12 in the receiver 10. A signal output from the FFT unit 42 is input to the broadcasting wave judging unit 33. If a broadcasting wave is present, it is expressed with signal levels. The broadcasting wave judging unit 33 can judge from the signal levels whether a broadcasting wave is present.
FIG. 7 shows an example in which the C mode is adapted to the B mode (FIG. 5). The C mode may also be adapted to the A mode (FIG. 3). Moreover, the operations of the receiver are identical to those of the A-mode and B-mode receivers (FIG. 4 and FIG. 6).

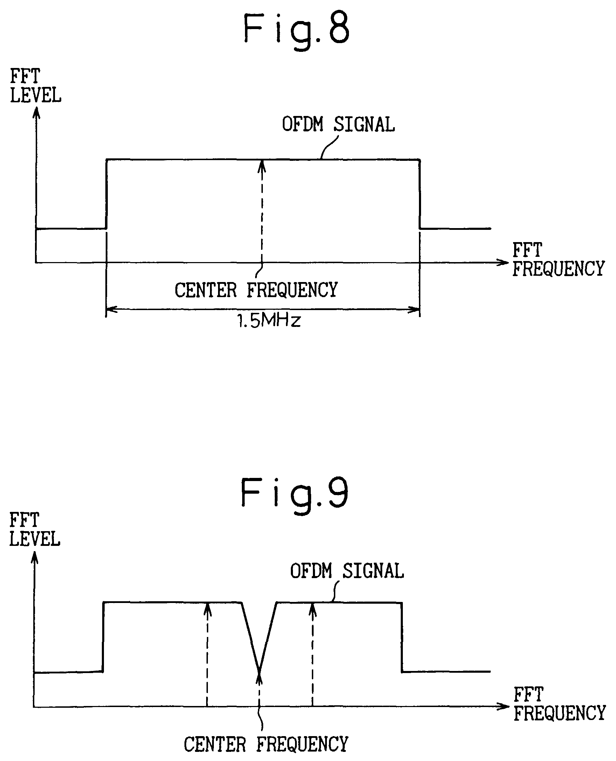

FIG. 8 to FIG. 11 are diagrams for explaining modes based on the C mode in which the broadcasting wave judging unit 33 judges from signal levels provided by the FFT unit 42 whether a broadcasting wave is present. FIG. 8 to FIG. 11 graphically express signal levels resulting from the FFT. The axis of abscissas indicates FFT frequencies, and the axis of ordinates indicates FFT levels.
If a broadcasting wave is present, that is, an OFDM-modulated signal (hereinafter OFDM signal) is present, carriers of the OFDM signal are distributed in a wide band of 1.5 MHz in width. No carrier is found in the other band.

In the mode shown in FIG. 8, a signal level of an OFDM signal at the center frequency is checked to see if the signal level exceeds a predetermined reference value. If so, it is judged that the OFDM signal is actually present. This mode makes it possible to simplify the circuitry for judgment.

In the mode expressed with FIG. 9, the signal level only at the center frequency is not checked but signal levels detected at frequencies near the center frequency are summed. If the sum exceeds a predetermined reference value, it is judged that an OFDM signal is present. In this mode, even if a signal level at a frequency decreases because of noise, the decrease is compensated for by signal levels at other frequencies and an OFDM signal can be detected reliably. In other words, if a noise is added to a signal component whose level is to be detected, the signal level decreases. Nevertheless, a correct judgment will be made.

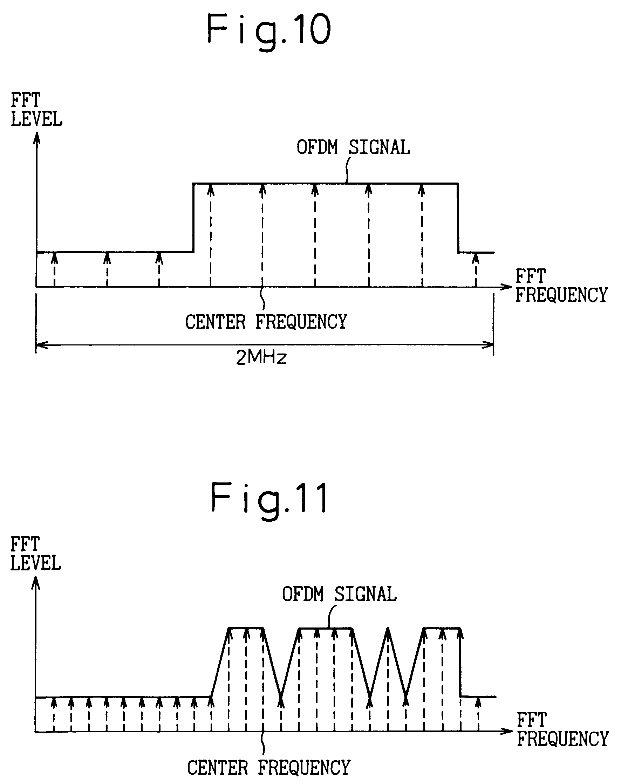

In the mode expressed with FIG. 10, signal levels, which are detected over a whole frequency band including the frequencies near the center frequency, are summed up. If the sum exceeds a predetermined reference value, it is judged that an OFDM signal is found. In this case, the range of frequencies at which a signal level is detected is extended up to a band within which the carriers of the OFDM signal are not found. A signal level is detected within a range of about 2 MHz in width. According to this mode, since the range of frequencies at which a signal level is detected is extended, even if the center frequency of an actual OFDM signal is deviated from a calculated value, the OFDM signal can be detected reliably.

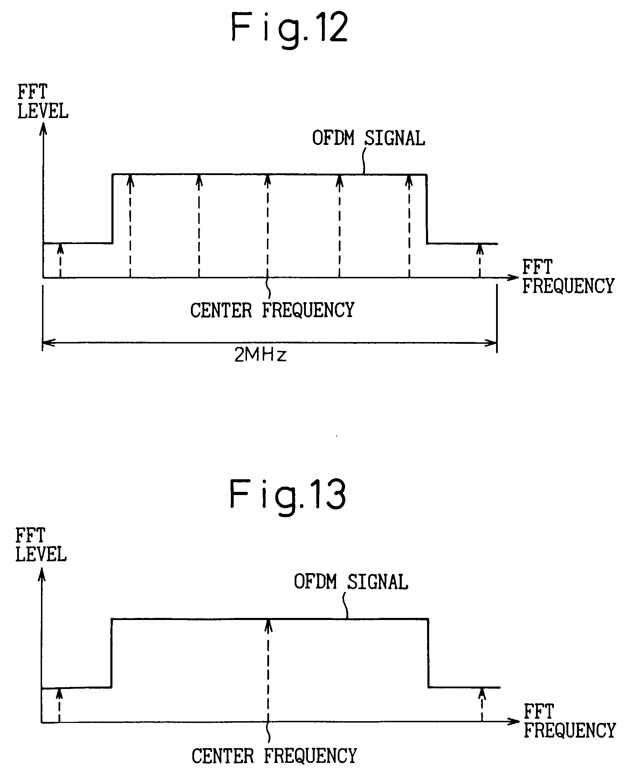

In the mode expressed with FIG. 11, signal levels detected within the range of 2 MHz wide are summed up in the same manner as those in the mode expressed with FIG. 10. All carriers (about 2000 FFT points) have the signal levels thereof detected. If the sum exceeds a predetermined reference value, it is judged that an OFDM signal is present. According to this mode, even if the center frequency of an actual OFDM signal is deviated from a calculated one, and some part thereof is missing due to a noise, the OFDM signal can be detected.

(D mode)

In the foregoing C mode, whether a broadcasting wave is present is judged from signal levels resulting from the FFT. By contrast, in a D mode, a plurality of signal levels resulting from the FFT over a frequency band is checked to detect a form defined by carriers and null carriers, and to thus judge whether a broadcasting wave is present.

In the mode shown in FIG. 12, signal levels are detected over a frequency band of 2 MHz in width. The form defined by carriers and null carriers is recognized based on the signal levels. Assume that high signal levels are detected at a plurality of points near the point of the center frequency and low signal levels are recognized at points near the limits of the frequency band. In this case, a wide form is defined by carriers, which is characteristic of OFDM. It is therefore judged that a broadcasting wave is present. Other radio waves of analog signals including a television broadcasting wave have a waveform demonstrating that the bandwidth of a carrier is narrow. According to the D mode, the OFDM signal can be distinguished clearly from the analog broadcasting signals. The presence of the OFDM signal can therefore be judged more accurately.

In the mode expressed with FIG. 13, a signal level near the center of a frequency band and a signal level near a limit thereof are detected in the same manner as those in the D mode. The signal level near the limit is subtracted from the signal level near the center. If the difference exceeds a predetermined value, a form is recognized having a boss near the center thereof. It is therefore judged that an OFDM signal is present.

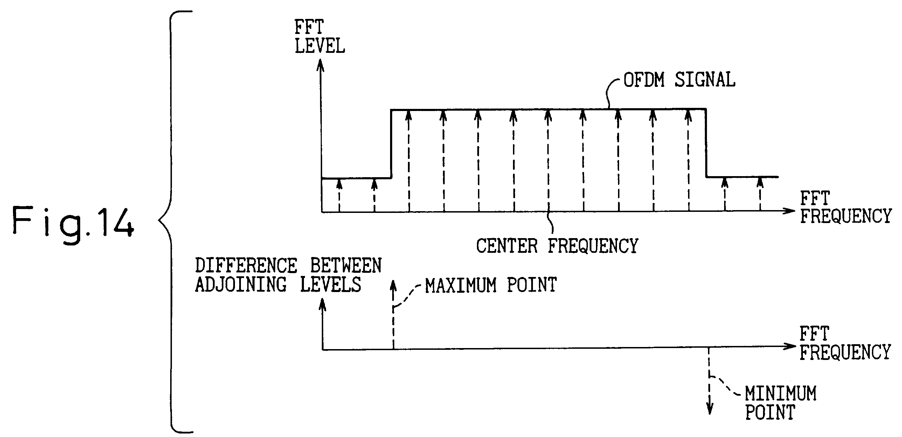

In the mode expressed with FIG. 14, whether an OFDM signal is present is judged by checking border points between carriers and null carriers. Signal levels are detected over a frequency band of 2 MHz in width. A difference between adjoining signal levels is calculated. Points are then detected, which are a point between points of signal levels whose difference is a maximum, and a point between points of signal levels whose difference is a minimum. These points are, as apparent from the drawing, border points between the carriers and null carriers. Consequently, the carriers are regarded to be present between the points of the maximum and minimum level differences. Eventually, it can be judged whether an OFDM signal is present.

(E mode)

A mode based on the foregoing D mode will be described as an E mode. Specifically, a threshold level is specified. Signal components whose levels are higher than the threshold level are regarded as carriers, and signal components whose levels are lower are regarded as null carriers. When the spectrum exhibits a convex form, it is judged that an OFDM signal is present. In this mode, a wide spread of carriers, which is characteristic of OFDM, can be identified reliably. Whether an OFDM signal is present can therefore be judged more accurately.

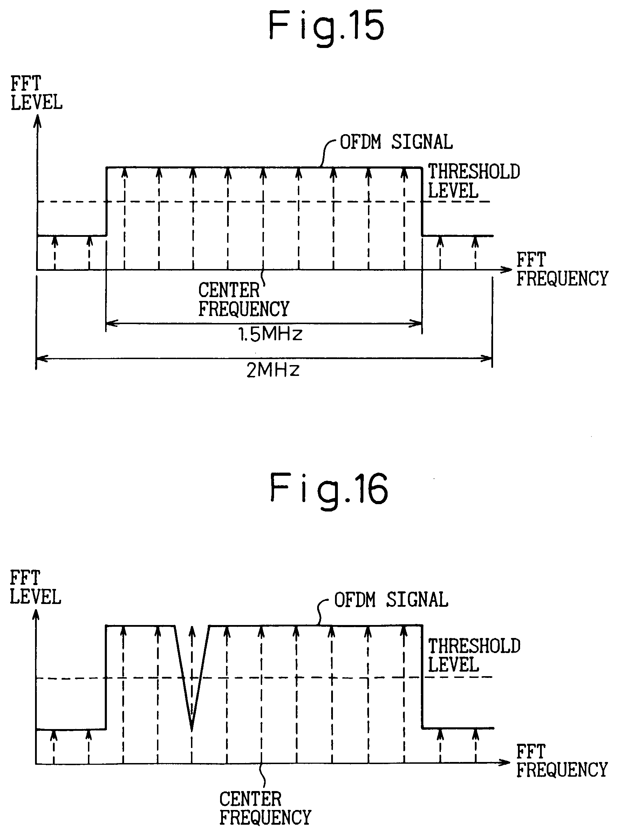

In the mode expressed with FIG. 15, signal levels at a plurality of points over a frequency band of 2 MHz wide are checked to see if they are higher or lower than a threshold level. The signal components whose levels are higher are identified as carriers, and the signal components whose levels are lower are identified as null carriers. When the spectrum exhibits a convex form, it is judged that an OFDM signal is present.

Any method can be adopted in order to specify the threshold level. One method is such that signal levels at a plurality of points are summed up and averaged, and the threshold level is set to a value proportional to the average level.

Moreover, when a spectrum is seen exhibiting a convex form, it is judged that an OFDM signal is present under the condition mentioned below. That is to say, the width of the upper side of the convex form is approximately the width of the spread of carriers resulting from OFDM (1.5 MHz in the illustrated example). Consequently, whether the OFDM signal is present can be judged more accurately.

The mode expressed with FIG. 16 is based on the E mode. When a spectrum is seen exhibiting irregularities, irregularities whose widths are small are ignored. The spectrum is then inspected. As shown in FIG. 16, a carrier of an OFDM signal may be lost because of a noise, and a concave part may be created in the spectrum. If the width of the concave part is small, it is judged that the concave part stems from the noise. The concave part is ignored and the spectrum is inspected. That a misjudgment is made because of a noise will not occur.

Incidentally, the influence of a noise may appear in a null carrier or may appear as a convex part of a spectrum but not as a concave part thereof. In this case, if the width of the convex part is small, the convex part is ignored. If the widths of irregularities are large, the spectrum is inspected in consideration of the irregularities.

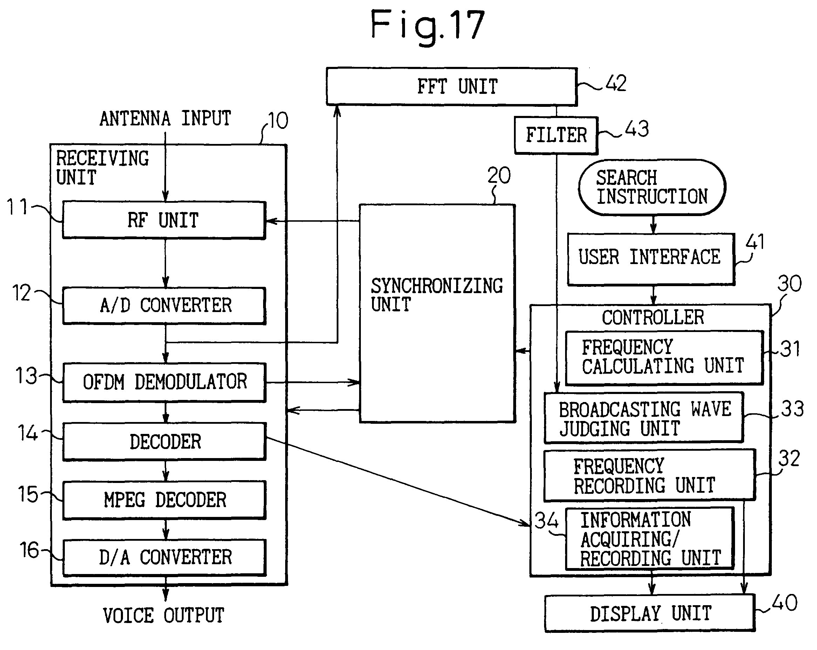

FIG. 17 shows the circuitry intended to remove the influence of a noise. The circuitry shown in FIG. 17 is such that a filter is included on the output stage of the FFT unit 42 included in the receiver shown in FIG. 7 (C mode). Consequently, since an OFDM signal is filtered, a missing part of a spectrum stemming from a noise is removed therefrom. Thus, the influence of the noise is eliminated, and an accurate judgment can be made.

The circuitry shown in FIG. 17 can be adapted to the modes described in conjunction with FIG. 8 to FIG. 16.

(F mode)

In the aforesaid C mode, the receiver has, as shown in FIG. 7 or FIG. 17, the FFT unit 42 included in the digital block of the receiving unit so as to obtain a result of FFT. By contrast, in an F mode, resultant data of the FFT is employed and supplied to the OFDM demodulator 13. The F mode will be described below.

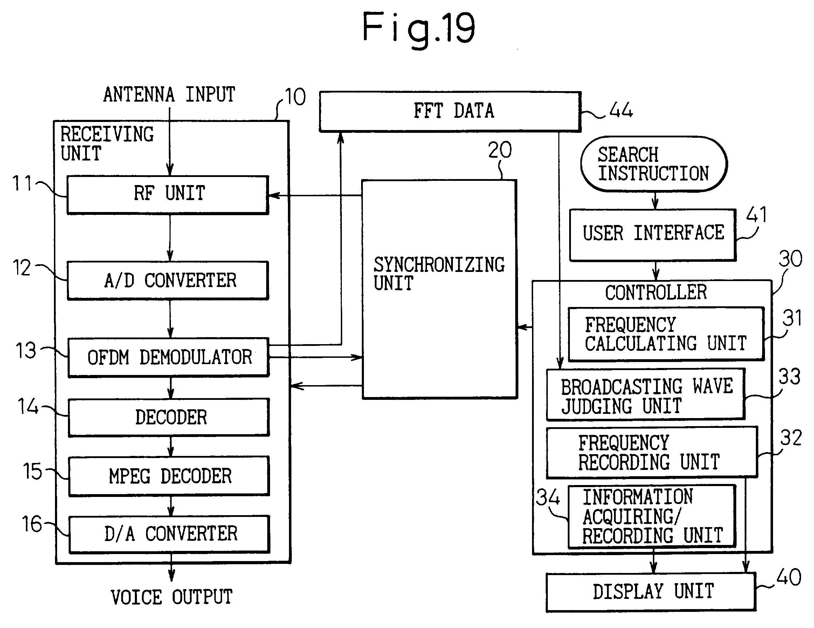

FIG. 19 shows the configuration of an F-mode digital broadcast receiver. The configuration is nearly identical to that of the receiver shown in FIG. 7. Only the difference from the one shown in FIG. 7 will be described below.

In the F mode, FFT data 44 is fetched from the OFDM demodulator 13 and input to the broadcasting wave judging unit 33. An IC realizing the OFDM demodulator 13 includes an FFT unit. Moreover, according to the F mode, when frequencies are checked to search for an OFDM signal, the IC is unemployed. The F mode therefore obviates the necessity of the IC realizing the FFT unit 42 included in the receiver shown in FIG. 7 or FIG. 17. This results in a decrease in cost.

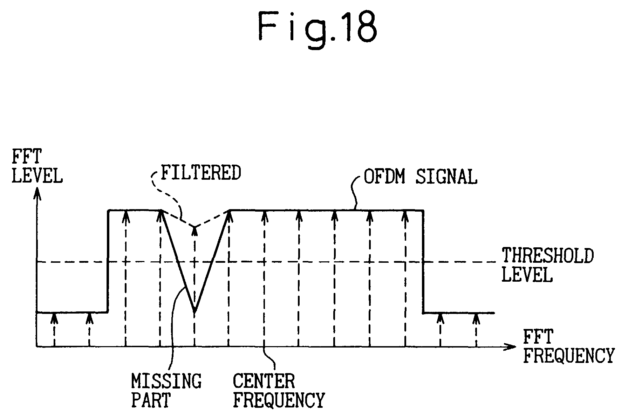

The F mode can be adapted to the receiver shown in FIG. 17. Moreover, the operations to be performed in the F mode are identical to those to be performed in the C mode. The method of judgment described in conjunction with FIG. 8 to FIG. 18 can be adopted.

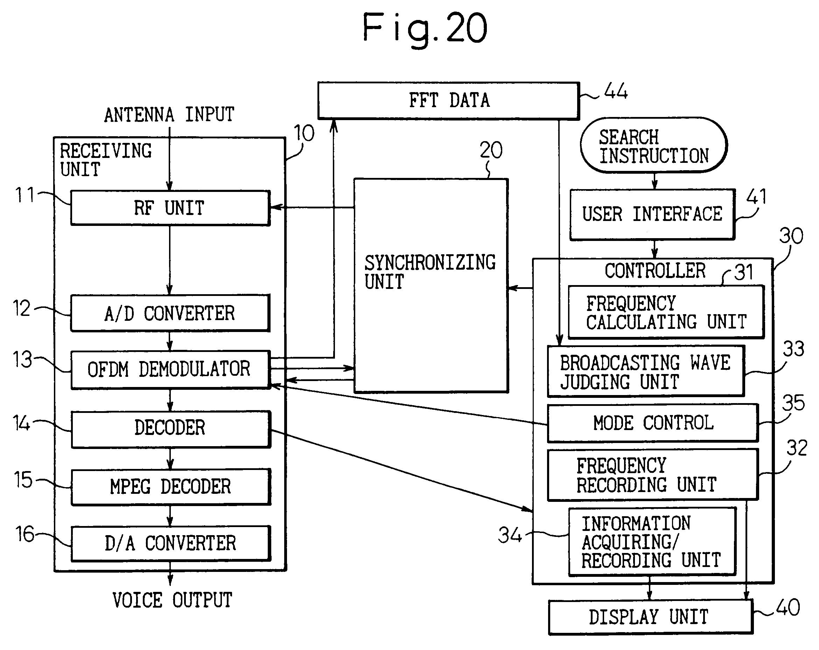

FIG. 20 shows the configuration of an F-mode receiver that can search for an OFDM signal irrespective of a transmission mode. A mode control unit 35 is included in the controller 30. The mode control unit 35 sets the OFDM demodulator 13 to a transmission mode for treating a minimum number of carriers.

In OFDM, three kinds of transmission modes; mode I, mode II, and mode III are available. The number of carriers (number of FFT points) is varied depending on the mode. In the F mode, the number of FFT points is set to the value specified in mode III intended to treat the smallest number of FFT points. For judging whether an OFDM signal is present as mentioned above, the number of FFT points may be small. The F mode can therefore make a correct judgment. Moreover, since the number of FFT points can be decreased, the time required for judgment is shortened.

(G mode)

In the aforesaid C to F modes, the digital block of the receiver judges whether a broadcasting wave is present. By contrast, whether a broadcasting wave is present is judged by the analog block of a receiver in a G mode. The G mode will be described below.

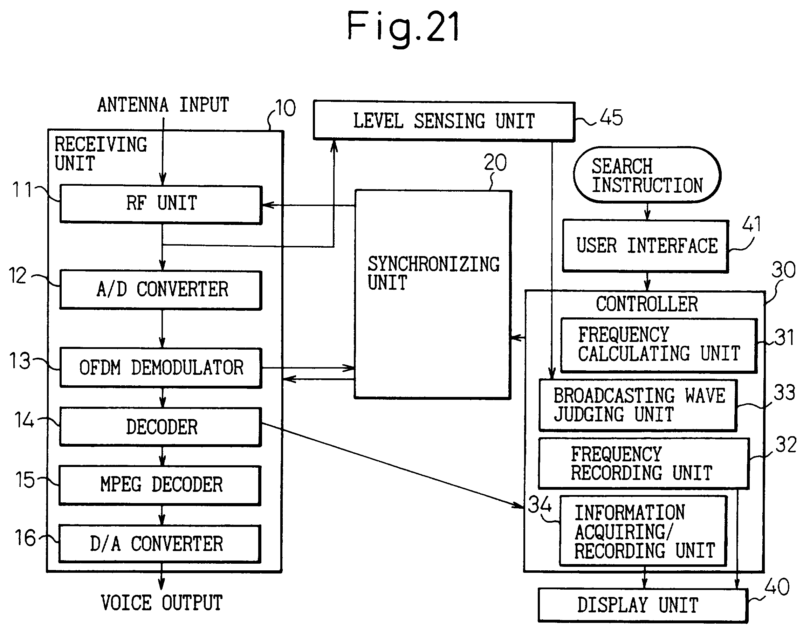

FIG. 21 shows the configuration of a G-mode receiver. An example of adapting the G mode to the B mode shown in FIG. 5 is shown in FIG. 21. The G mode is also adaptable to the A mode (FIG. 3).

A description of the configuration shown in FIG. 21 is centered on a difference from the one shown in FIG. 5. A level sensing unit 45 is connected to the analog block on the output stage of the RF unit 11 of the receiver 10. An output of the level sensing unit 45 is input to the broadcasting wave judging unit 33. If a broadcasting wave is present at frequencies being checked during searching, an output signal of the level sensing unit 45 exhibits a specific signal level. The broadcasting wave judging unit 33 can judge from the signal level whether a broadcasting wave is present.

EP 0 938 199 A2

Moreover, since the analog block is employed for judgment, it can be judged whether a higher-frequency broadcasting wave is present. The operations of the receiver are identical to those of the A-mode or B-mode receiver.

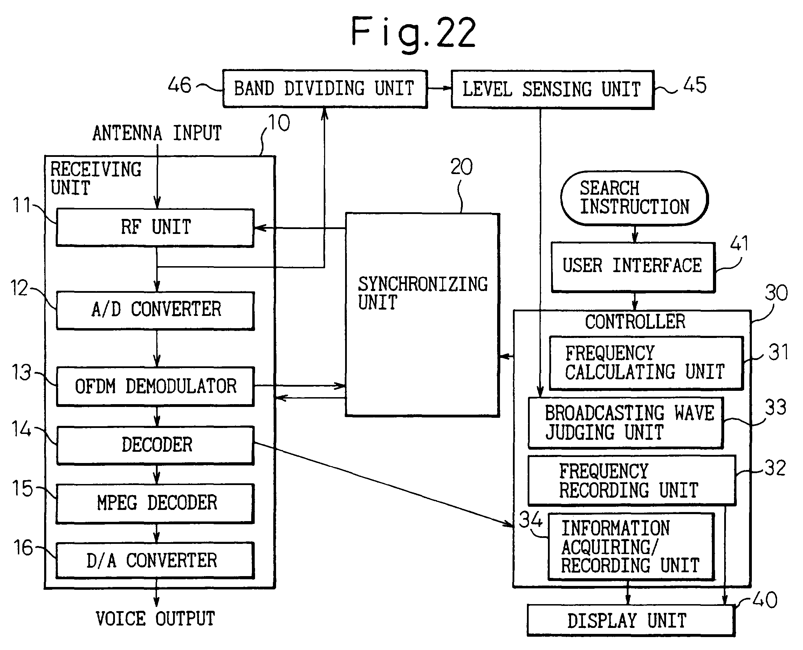

FIG. 22 shows a variant of a G-mode receiver.

The receiver shown in FIG. 22 has a band dividing unit 46 inserted to the stage preceding the level sensing unit 45. The band dividing unit 46 divides frequencies into a band in which an OFDM signal is present and a band in which the OFDM signal is absent. The level sensing unit 45 senses signal levels relative to the respective bands. It is then checked if two conditions are satisfied: the condition that signal levels are detected in the band in which the OFDM signal is present, and the condition that no signal level is detected in the other band. If the conditions are satisfied, it is judged that a broadcasting wave is present.

In the aforesaid C to G modes, OFDM demodulation is adopted. A DAB signal spends a null time, during which it exhibits a null level, between frames. Assuming that a signal level is detected in order to judge whether broadcasting waves are present during the null time, in this case, since the signal level is null, it may be judged that no receivable signal is present, though a receivable signal is present.

To avoid misjudgment, when a signal like the DAB signal has null time, the signal is checked continuously over a time interval longer than the null time. It is then judged whether a broadcasting wave is present. Thus, even if the first signal detection coincides with the null time, the second signal detection will match the timing that a receivable signal can be detected reliably. Consequently, an OFDM-modulated DAB signal can be detected more reliably.

**Claims**

1. A digital broadcast receiver having a receiving unit, a synchronising unit, a control unit, and a display unit,
   wherein said control unit comprises:

   a frequency calculating unit for calculating frequencies at which receivable broadcast information is searched for;
   a broadcasting wave judging unit for judging whether a broadcasting wave is present at the frequencies calculated by said calculating unit;
   a frequency recording unit in which frequencies, at which said broadcasting wave judging unit has judged that the broadcasting wave is present, are recorded; and
   an information recording unit in which acquired information is recorded, and
   in said control unit, said frequency calculating unit calculates frequencies; the calculated frequencies are set as radio frequencies to be monitored in said receiving unit; said broadcasting wave judging unit judges whether the broadcasting wave is present at each of the frequencies; frequencies at which the broadcasting wave is present are recorded in said frequency recording unit; after judging whether a broadcasting wave is present is completed relative to all the frequencies, the frequencies recorded in said frequency recording unit are set as radio frequencies to be received in said receiving unit; said synchronizing unit helps attain synchronism; the broadcast information read from said receiving unit is recorded in said information recording unit; and the contents of the information recorded in said information recording unit are displayed on said display unit.

2. A digital broadcast receiver according to claim 1, wherein said broadcasting wave judging unit senses whether a signal resulting from an FFT, which is performed by the digital block of said receiving unit, is present, and thus judges whether the broadcasting wave is present.

3. A digital broadcast receiver according to claim 2, wherein said broadcasting judging unit checks a signal level at the center frequency of the signal resulting from an FFT, and senses based on the signal level whether the signal resulting from an FFT is present.

4. A digital broadcast receiver according to claim 2, wherein said broadcasting wave judging unit sums up signal levels detected at a plurality of frequencies near the center frequency of the signal resulting from an FFT, and senses based on the sum whether the signal resulting from an FFT is present.

5. A digital broadcast receiver according to claim 2, wherein said broadcasting wave judging unit sums up signal levels detected at a plurality of frequencies over the whole frequency band of the signal resulting from an FFT, and senses based on the sum whether the signal resulting from an FFT is present.

6. A digital broadcast receiver according to claim 2, wherein said broadcasting wave judging unit sums up signal levels detected at all the frequencies in the whole frequency band of the signal resulting from an FFT, and senses based on the sum whether the signal resulting from an FFT is present.

7. A digital broadcast receiver according to claim 2, wherein said broadcasting wave judging unit checks signal levels at a plurality of frequencies in the whole frequency band of the signal resulting from an FFT so as to inspect a form defined by null carriers and carriers, and thus senses whether the signal resulting from an FFT is present.

8. A digital broadcast receiver according to claim 7, wherein said broadcasting wave judging unit checks signal levels at frequencies near the center frequency of the whole frequency band and at frequencies near the limits thereof so as to inspect a form defined by null carriers and carriers.

9. A digital broadcast receiver according to claim 7, wherein said broadcasting wave judging unit calculates a difference in signal level between adjoining frequencies in the whole frequency band, and inspects a form defined by the carriers on the assumption that the carriers are present between points at which the level difference is maximum and minimum.

10. A digital broadcast receiver according to claim 7, wherein said broadcasting wave judging unit regards signal components, of which the levels are higher than a predetermined threshold level, as carriers, regards signal components, of which the levels are lower, as null carriers, and inspects the form defined by the carriers.

11. A digital broadcast receiver according to claim 10, said broadcasting wave judging unit determines the predetermined threshold according to an average of signal levels detected over the whole frequency band.

12. A digital broadcast receiver according to claim 10, wherein said broadcasting wave judging unit ignores irregularities, whose widths are small, of a form defined by carriers and null carriers.

13. A digital broadcast receiver according to claim 10, wherein when the width of the upper side of a concave form defined by carries and null carriers is approximate to a predetermined width of the spread of carriers, said broadcasting wave judging unit senses that the signal resulting from FFT is present.

14. A digital broadcast receiver according to claim 2, wherein said broadcasting wave judging unit filters a spectrum resulting from FFT, then senses whether the signal resulting from FFT is present, and thus judges whether the broadcasting wave is present.

15. A digital broadcast receiver according to claim 2, wherein said broadcasting wave judging unit judges from the results of FFT to be supplied to an OFDM demodulator in said receiving unit whether the broadcasting wave is present.

16. A digital broadcast receiver according to claim 15, wherein said broadcasting wave judging unit sets the number of FFT points to the number of carriers specified in a mode intended to treat the smallest number of carriers.

17. A receiver according to any of the preceding claims, wherein a level sensing unit is included in the analog block of said receiving unit, and said broadcasting wave judging unit judges from signal levels sensed by said level sensing unit whether the broadcasting wave is present.

18. A digital broadcast receiver according to claim 17, wherein a band dividing unit is installed at a stage preceding said level sensing unit.

19. A digital broadcast receiver according to claim 2, wherein said broadcasting wave judging unit makes a judgement continuously over a time interval longer than a null time.

20. A digital broadcast receiver according to any of the preceding claims, wherein the frequencies at which the broadcasting wave is present are displayed on said display unit; and wherein the contents of the acquired information are additionally displayed on said display unit displaying the frequencies.

# Fig.1

ANTENNA INPUT

RECEIVING UNIT 10

20

SEARCH INSTRUCTION

41

USER INTERFACE

11 — RF UNIT

SYNCHRONIZING UNIT

30

CONTROLLER

12 — A/D CONVERTER

13 — OFDM DEMODULATOR

FREQUENCY CALCULATING UNIT

31

14 — DECODER

34

15 — MPEG DECODER

INFORMATION ACQUIRING/ RECORDING UNIT

16 — D/A CONVERTER

VOICE OUTPUT

40 — DISPLAY UNIT

EP 0 938 199 A2

# Fig.2

```
        ( START SEARCHING )
                 │
                 ▼
   ┌─────────────────────────┐  S11
   │  CALCULATE FREQUENCIES  │
   └─────────────────────────┘
                 │
                 ▼
            ╱─────────╲  S12
      Y    ╱  IS IT LAST ╲
    ◄──────   FREQUENCY?  ────
            ╲─────────╱
                 │ N
                 ▼
   ┌─────────────────────────┐  S13
   │   SET RADIO FREQUENCIES │
   └─────────────────────────┘
                 │
                 ▼
   ┌─────────────────────────┐  S14
   │    ATTAIN SYNCHRONISM   │
   └─────────────────────────┘
                 │
                 ▼
  S15    ╱─────────────╲
        ╱ CAN INFORMATION ╲   N
        ╲ BE ACQUIRED?    ────►
         ╲───────────────╱
                 │ Y
                 ▼
   ┌─────────────────────────┐  S16
   │    RECORD INFORMATION   │
   └─────────────────────────┘
                 │
                 ▼
   ┌─────────────────────────┐  S17
   │  DISPLAY ALL INFORMATION│
   └─────────────────────────┘
                 │
                 ▼
      ( TERMINATE SEARCHING )
```

# Fig.3

ANTENNA INPUT

SEARCH INSTRUCTION

RECEIVING UNIT — 10

20

USER INTERFACE — 41

11 — RF UNIT

SYNCHRONIZING UNIT

12 — A/D CONVERTER

CONTROLLER — 30

13 — OFDM DEMODULATOR

FREQUENCY CALCULATING UNIT — 31

14 — DECODER

FREQUENCY RECORDING UNIT — 32

15 — MPEG DECODER

BROADCASTING WAVE JUDGING UNIT — 33

16 — D/A CONVERTER

INFORMATION ACQUIRING/ RECORDING UNIT — 34

VOICE OUTPUT

DISPLAY UNIT — 40

EP 0 938 199 A2

# Fig.4

```
        ( START SEARCHING )
                │
S31 ──  CALCULATE FREQUENCIES  ←──────────┐
                │                          │
        ┌───────────────┐  S32             │
     Y ─┤  IS IT LAST    │                 │
   ←─────┤ FREQUENCY?    │                 │
        └───────────────┘                 │
                │ N                        │
        SET RADIO FREQUENCIES  S33         │
                │                          │
        ┌────────────────┐ S34             │
S34 ────┤ IS BROADCASTING  │── N ──→       │
        │ WAVE PRESENT?    │               │
        └────────────────┘                │
                │ Y                        │
S35 ──  RECORD FREQUENCIES                 │
                │                          │
                └──────────────────────────┘

S41 ──  READ RECORDED FREQUENCIES
                │
        ┌───────────────┐  S42
     Y ─┤  IS IT LAST    │
   ←─────┤ FREQUENCY?    │
        └───────────────┘
                │ N
        SET RADIO FREQUENCIES  S43
                │
        ATTAIN SYNCHRONISM  S44
                │
        ACQUIRE AND
        RECORD INFORMATION  S45
                │
        DISPLAY ALL INFORMATION  S51
                │
        ( TERMINATE SEARCHING )
```

# Fig.5

ANTENNA INPUT

RECEIVING UNIT  10

SEARCH INSTRUCTION  41

11 — RF UNIT

20  SYNCHRONIZING UNIT

USER INTERFACE

12 — A/D CONVERTER

CONTROLLER  30

13 — OFDM DEMODULATOR

FREQUENCY CALCULATING UNIT  31

14 — DECODER

FREQUENCY RECORDING UNIT  32

15 — MPEG DECODER

BROADCASTING WAVE JUDGING UNIT  33

16 — D/A CONVERTER

34  INFORMATION ACQUIRING/ RECORDING UNIT

VOICE OUTPUT

40  DISPLAY UNIT

EP 0 938 199 A2

14

Fig.6

```
                    ┌────────────────────┐
                    │  START SEARCHING   │
                    └────────────────────┘
                              │
    S31 ──┐   ┌──────────────────────────────┐
          └──▶│    CALCULATE FREQUENCIES     │
              └──────────────────────────────┘
                              │
          Y    ╱─────────────────────╲   S32
        ◀──────   IS IT LAST          ╲──
              ╲   FREQUENCY?          ╱
    S32        ╲─────────────────────╱
          │               │ N
          │     ┌──────────────────────────────┐
    S33 ──┘     │    SET RADIO FREQUENCIES      │
          │     └──────────────────────────────┘
          │               │
          │    ╱─────────────────────╲      N
          │   ╱   IS BROADCASTING      ╲──────▶
          │   ╲   WAVE PRESENT?        ╱
    S34 ──┘    ╲─────────────────────╱
          │               │ Y
          │     ┌──────────────────────────────┐
    S35 ──┘     │      RECORD FREQUENCIES       │
          │     └──────────────────────────────┘
          │               │
          │     ┌──────────────────────────────┐
          │     │     DISPLAY FREQUENCIES       │
    S36 ──┘     └──────────────────────────────┘
          │               │
    ┌ ─ ─ ─ ─ ─ ─ ─ ─ ─ ─ ─ ┐
    │ (DISPLAY FREQUENCIES) │ ─ ─ S37
    └ ─ ─ ─ ─ ─ ─ ─ ─ ─ ─ ─ ┘
                              │
    S41 ──┐  ┌──────────────────────────────┐
          └─▶│  READ RECORDED FREQUENCIES   │
             └──────────────────────────────┘
                              │
          Y    ╱─────────────────────╲
        ◀──────   IS IT LAST          ╲──── S42
              ╲   FREQUENCY?          ╱
    S43 ──┐    ╲─────────────────────╱
          │               │ N
          │     ┌──────────────────────────────┐
    S44 ──┘     │    SET RADIO FREQUENCIES      │
          │     └──────────────────────────────┘
          │               │
          │     ┌──────────────────────────────┐
    S45 ──┘     │      ATTAIN SYNCHRONISM       │
          │     └──────────────────────────────┘
          │               │
          │     ┌──────────────────────────────┐
          │     │      ACQUIRE AND             │
    S46 ──┘     │      RECORD INFORMATION      │
          │     └──────────────────────────────┘
          │               │
          │     ┌──────────────────────────────┐
          │     │     DISPLAY ADDITIONAL       │
          │     │     INFORMATION              │
          │     └──────────────────────────────┘
    ┌ ─ ─ ─ ─ ─ ─ ─ ─ ─ ─ ─ ┐
    │ (DISPLAY ADDITIONAL ) │ ─ ─ S47
    │  INFORMATION          │
    └ ─ ─ ─ ─ ─ ─ ─ ─ ─ ─ ─ ┘
                    ┌────────────────────┐
                    │ TERMINATE SEARCHING│
                    └────────────────────┘
```

# Fig.7

EP 0 938 199 A2

# Fig.8

FFT
LEVEL

OFDM SIGNAL

CENTER FREQUENCY

1.5MHz

FFT
FREQUENCY

# Fig.9

FFT
LEVEL

OFDM SIGNAL

FFT
FREQUENCY

CENTER FREQUENCY

# Fig.10

FFT
LEVEL

OFDM SIGNAL

FFT
FREQUENCY

CENTER FREQUENCY

2MHz

# Fig.11

FFT
LEVEL

OFDM SIGNAL

FFT
FREQUENCY

CENTER FREQUENCY

EP 0 938 199 A2

# Fig.12

FFT
LEVEL

OFDM SIGNAL

FFT
FREQUENCY

CENTER FREQUENCY

2MHz

# Fig.13

FFT
LEVEL

OFDM SIGNAL

FFT
FREQUENCY

CENTER FREQUENCY

EP 0 938 199 A2

# Fig.14

FFT
LEVEL

OFDM SIGNAL

FFT
FREQUENCY

CENTER FREQUENCY

DIFFERENCE BETWEEN
ADJOINING LEVELS

MAXIMUM POINT

FFT
FREQUENCY

MINIMUM
POINT

# Fig.15

# Fig.16

# Fig.17

EP 0 938 199 A2

# Fig.18

# Fig.19

ANTENNA INPUT

**RECEIVING UNIT** — 10

- RF UNIT — 11
- A/D CONVERTER — 12
- OFDM DEMODULATOR — 13
- DECODER — 14
- MPEG DECODER — 15
- D/A CONVERTER — 16

VOICE OUTPUT

FFT DATA — 44

SYNCHRONIZING UNIT — 20

SEARCH INSTRUCTION

USER INTERFACE — 41

**CONTROLLER** — 30

- FREQUENCY CALCULATING UNIT — 31
- BROADCASTING WAVE JUDGING UNIT — 33
- FREQUENCY RECORDING UNIT — 32
- INFORMATION ACQUIRING/ RECORDING UNIT — 34

DISPLAY UNIT — 40

EP 0 938 199 A2

# Fig.20

EP 0 938 199 A2

# Fig.21

ANTENNA INPUT

LEVEL SENSING UNIT ～45

RECEIVING UNIT /10

11 — RF UNIT

12 — A/D CONVERTER

13 — OFDM DEMODULATOR

14 — DECODER

15 — MPEG DECODER

16 — D/A CONVERTER

VOICE OUTPUT

SYNCHRONIZING UNIT 20

SEARCH INSTRUCTION

USER INTERFACE 41

CONTROLLER 30

FREQUENCY CALCULATING UNIT 31

BROADCASTING WAVE JUDGING UNIT 33

FREQUENCY RECORDING UNIT 32

34 INFORMATION ACQUIRING/ RECORDING UNIT

DISPLAY UNIT 40

EP 0 938 199 A2

# Fig.22

EP 0 938 199 A2

ANTENNA INPUT

46 ~ BAND DIVIDING UNIT → LEVEL SENSING UNIT ~ 45

RECEIVING UNIT — 10

20 — SYNCHRONIZING UNIT

SEARCH INSTRUCTION

11 — RF UNIT

41 — USER INTERFACE

CONTROLLER — 30

12 — A/D CONVERTER

FREQUENCY CALCULATING UNIT — 31

13 — OFDM DEMODULATOR

BROADCASTING WAVE JUDGING UNIT — 33

14 — DECODER

FREQUENCY RECORDING UNIT — 32

15 — MPEG DECODER

34 — INFORMATION ACQUIRING/ RECORDING UNIT

16 — D/A CONVERTER

DISPLAY UNIT — 40

VOICE OUTPUT

# Fig.23

FIRST
DETECTION   SECOND
            DETECTION

OFDM SIGNAL

TIME

FRAME SIGNAL

NULL
TIME

NULL
TIME